# EUROPEAN PATENT APPLICATION

(11) **EP 3 059 673 A1**
(43) Date of publication of application: **24.08.2016**
(21) Application number: 16155485.2
(22) Date of filing: 12.02.2016
(51) Int. Cl.: G06F 9/44, E21B 43/00, E21B 49/00, G01V 99/00

(54) **MOBILE APPLICATION SYSTEMS AND METHODS OF OPERATION**

(30) Priority: 20.02.2015 US 201514627548
(71) Applicant: Services Pétroliers Schlumberger, 75007 Paris (FR); Logined B.V., 2586 BJ S Gravenhage (NL)
(72) Inventor: MOGOU DESSAP, Jean-Paul, Sugar Land, TX Texas 77478 (US); HAJIZADEH, Yasin, Calgary, Alberta T2G 0P6 (CA)
(74) Representative: Schlumberger Cambridge Research Limited

(57) **Abstract**

The present invention is directed to systems and methods for mobile applications. A method may include establishing communication between a mobile device and a computing device and receiving input at the mobile device. Further, the method may include conveying data based on at least one simulation performed by the computing device via the mobile device. In addition, the method may include performing at least one operation at the mobile device at least partially based on the conveyed data.

## Description

### TECHNICAL FIELD

This disclosure relates generally to mobile application programs and, more specifically, to methods and systems for interacting with remote simulation applications via a mobile application.

### BRIEF SUMMARY OF THE INVENTION

In one specific embodiment, a method may include performing at least one operation at a mobile device. The method may also include establishing communication between the mobile device and a computing device and receiving input at the mobile device. Moreover, the method may include performing at least one simulation operation at the computing device at least partially based on input received at the mobile device. As an example, the at least one simulation operation may include performing at least one oil/gas reservoir simulation at the computing device. It is noted that the computing device may include a Cloud system. In addition, the method may include transmitting the generated data to the mobile device, and performing at least one additional operation at the mobile device at least partially based on the data generated by the computing device.

In another specific embodiment, a method includes establishing communication between a mobile device and a computing device and receiving input at the mobile device. The method may also include conveying data based on at least one simulation at the computing device via the mobile device. The data may, for example only, relate to at least one oil/gas reservoir simulation. Furthermore, the method may include performing at least one operation at the mobile device at least partially based on the data generated by the computing device.

Another embodiment may include a method comprising performing at least one simulation operation at the computing device at least partially based on input received at a mobile device and generating data in response to performing the at least one simulation operation. As an example, the at least one simulation operation may include an oil/gas reservoir simulation. Further, the method may include conveying the generated data to the mobile device.

Another embodiment includes a system comprising a mobile device including an application program. The system may also include a computing device communicatively coupled to the mobile device and including another application program configured to generate and convey simulation data to the application program of the mobile device. As an example, the application program on the computing device may be configured to perform one or more oil/gas reservoir simulations, and the generated simulation data may relate to the one or more oil reservoir simulations.

Yet other embodiments of the present invention comprise computer-readable media storage storing instructions that when executed by a processor cause the processor to perform instructions in accordance with one or more embodiments described herein.

As will be appreciated, various embodiments disclosed herein may ease the interaction with simulation models (e.g., setting up simulation cases and presentation of simulation results). Various embodiments may provide an intuitive mechanism to interact with reservoir simulation models using mobile devices (e.g., smartphones and tablets) to increase mobility and enhance user experience in dealing with simulation models.

It will be appreciated that the foregoing summary is merely intended to introduce a subset of the subject matter discussed below and is, therefore, not limiting. Further, other aspects, as well as features and advantages of various aspects, of the present invention will become apparent to those of skill in the art through consideration of the ensuing description, the accompanying drawings and the appended claims.

### BRIEF DESCRIPTION OF THE DRAWINGS

FIGS. 1A and 1B depict a system including a mobile device and a computing device, in accordance with an embodiment of the present disclosure;
FIG. 2 is a depiction of an example screen display on a mobile device;
FIG. 3 is an example visualization of time series data displayed via a mobile device;
FIG. 4 is an example visualization of an example of message center displayed via a mobile device;
FIG. 5 is a flowchart depicting a method, in accordance with an embodiment of the present invention
FIG. 6 is an example visualization of simulation results displayed via a mobile device;
FIG. 7 is another example visualization of simulation results displayed via a mobile device;
FIG. 8 is another example visualization of simulation results displayed via a mobile device;
FIG. 9 is another example visualization of simulation results displayed via a mobile device;
FIG. 10 is yet another example visualization of simulation results displayed via a mobile device;
FIG. 11 is a flowchart depicting another method, according to an embodiment of the present disclosure;
FIG. 12 is a flowchart depicting yet another method, in accordance with an embodiment of the present invention; and
FIG. 13 illustrates a system, in accordance with an embodiment of the present disclosure.

### DETAILED DESCRIPTION

Referring in general to the accompanying drawings, various embodiments of the present invention are illustrated to show the structure and methods for interacting with remote simulation applications via a mobile application. Common elements of the illustrated embodiments are designated with like numerals. It should be understood that the figures presented are not meant to be illustrative of actual views of any particular portion of the actual device structure, but are merely schematic representations which are employed to more clearly and fully depict embodiments of the disclosure.

The following provides a more detailed description of the present disclosure and various representative embodiments thereof. In this description, functions may be shown in block diagram form in order not to obscure the present invention in unnecessary detail. Additionally, block definitions and partitioning of logic between various blocks is exemplary of a specific implementation. It will be readily apparent to one of ordinary skill in the art that the present invention may be practiced by numerous other partitioning solutions. For the most part, details concerning timing considerations and the like have been omitted where such details are not necessary to obtain a complete understanding of the present invention and are within the abilities of persons of ordinary skill in the relevant art. While several embodiments and features of the present invention are described herein, modifications, adaptations, and other implementations are possible, without departing from the spirit and scope of the present invention.

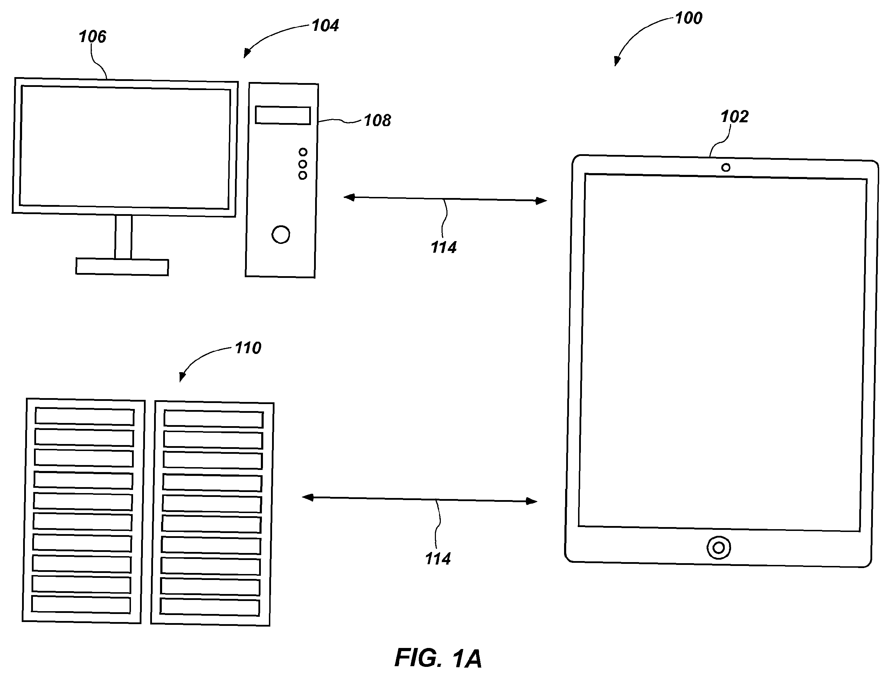

According to various embodiments disclosed herein include a mobile application program configured to interact with one or more application programs (e.g., reservoir simulation software) stored on a remote computing device. Various embodiments of the present disclosure may enhance user experience for simulation case management. Further, various embodiments may ease interaction with models (e.g., reservoir models) and may enhance data management and collaboration (e.g., among colleagues) in the same or different locations using a mobile device (e.g., cell phones and tablets). FIG. 1A illustrates a system 100 including a mobile device 102, a computing device 104, and one or more computers 110 (e.g., a cluster of computers). As illustrated, computing device 104 may include a computing unit 108 and a display device 106 (e.g., a computer monitor). It is noted that computing device 104 may include one or more desktop computers, one or more laptop computers, or any combination thereof.

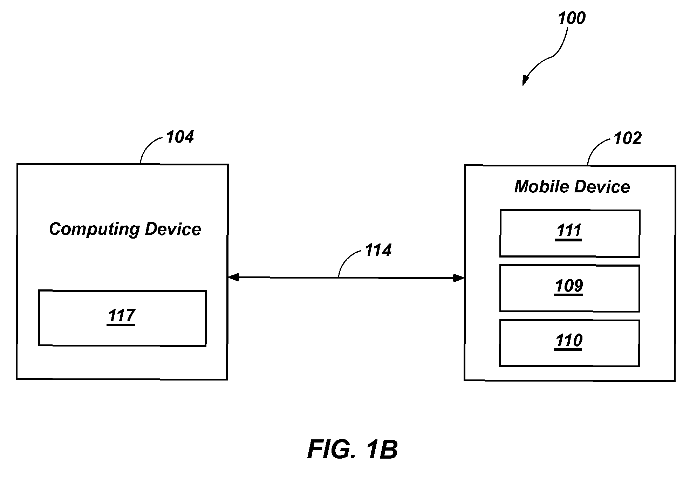

With reference to FIG. 1B, mobile device 102, which may be remote from computing device 104, may include any suitable mobile device. Mobile device 102 may include one or more application programs 109, memory 110, and a graphical user interface (GUI) 111, which may include one or more input/output (I/O) devices, such as a display device. Mobile device 102, which may comprise a touch screen, may be communicatively coupled to each of computing unit 108 and computer 110 via a communication link 114, which may comprise a wired communication link, a wireless communication link, or a combination thereof. In one specific example, communication link 114 may comprise a two-way HTTP/HTTPS, a remote communication protocol, or both.

In accordance with one embodiment, computing unit 108 may include one or more application programs (e.g., simulation software) 117, which may be configured to run one or more simulations. As a non-limiting example, application program 117 may comprise Petrel® (owned by Schlumberger of Houston, Texas), Intersect® (also owned by Schlumberger), Eclipse® (also owned by Schlumberger), and the like. Further, application programs 109 may be configured to interface with computing device 104 for performing various tasks (e.g., to edit an input simulation deck, launch a simulation, view simulation results, retrieve simulation results or any combination thereof). For example only, simulation results may include time series data (e.g., oil production rates) or the models match to observed field data.

Application programs 109 may be configured to build simulations on computing device 104, launch simulations on computing device 104, control simulations on computing device 104, or a combination thereof. Further, upon completion of a simulation, data may be provided from computing device 104 to mobile device 102. In one example, the data may comprise one or more graphs for visualizing results of one or more simulations. It is noted that in one embodiment, application program 109 may be associated with a license for application program (e.g., simulation software) 117 on computing device 104.

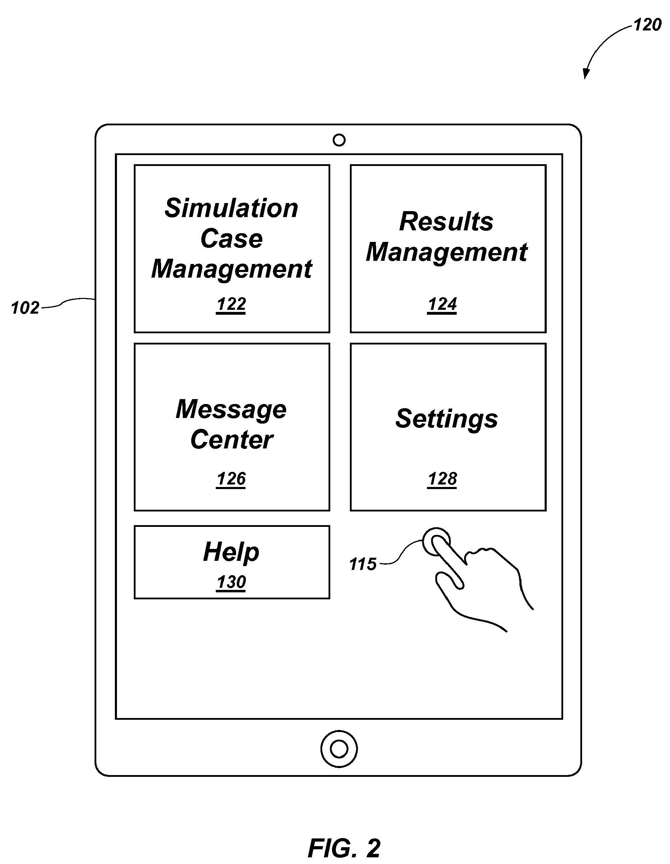

FIG. 2 is a depiction of an example screen display 120 on mobile device 102. Screen display 120 may include various menu items, such as, for example only, simulation case management 122, results management 124, message center 126, settings 128, and help 130. According to one example, simulation case management 122 may link application program 109 to various simulator environments to launch simulations (e.g., to launch reservoir simulations). Example simulator environments may include Petrel® Reservoir Engineering, Intersect® and Eclipse®.

According to some embodiments, each application program (e.g., simulation environment) 117 on computing device 104 may have its own graphical user interface (GUI) displayed on mobile device 102. For example, a user, via mobile device 102, may prepare and launch a simulation model on computing device 104. Further, a user can write a simulation deck and/or load a simulation deck remotely from mobile device 102. Further, a user may perform a quality check on the data deck. In addition, sections of the data deck, and possibly keywords, may be displayed via remote device 102 using different colors for the ease of reading and editing. Further, a camera icon 115 may appear via screen display 120 to capture screenshots, which may be stored in mobile device 102 and/or on a remote device, such as computer 110. Data stored on mobile device 102 may be conveyed to other devices (e.g., computer 110) through one or more suitable communication protocols. It is noted that a user may enter input to mobile device 102 via any know method (e.g., voice control, keyboard, touch screen, etc.).

Results management 124 includes several options for viewing and/or receiving data from computing device 104. For example, results management 124 may enable a user to check simulation results, view simulation results, or both. Simulation results may include, but are not limited to, reservoir models, time series, etc. A reservoir model option may include visualization of static and dynamic cell properties in a simulation model. Data displayed via mobile device 102 may be customized and a scroll option may be available (i.e., to scroll through various simulation jobs and status). Further, screen display 120 may include a slide bar for reviewing time steps for simulations. In addition, screen display 120 may include a time series option for visualizing reservoir data that is dependent on time, such as production rates, injection rates, pressures, etc. It is noted that various options (i.e., settings of screen display 102) may be altered by a user via settings 128.

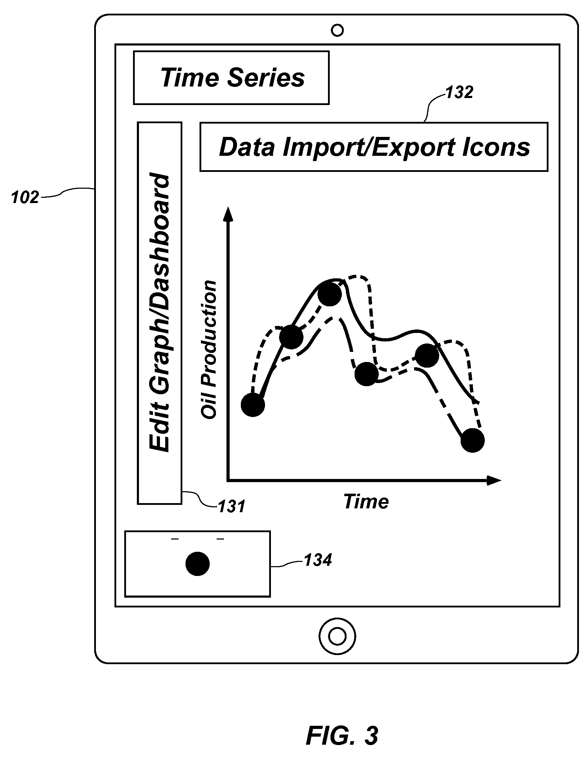

With reference to FIG. 3, an example visualization of time series data is displayed via mobile device 102. More specifically, in FIG. 3, an "Oil Production" versus "Time" plot is depicted. It is noted that multiple time series/models can be imported and visualized in one or more windows displayed via mobile device 102. An Edit Graph/Dashboard 131 may include options to change the scale and captions, rearrange plots and/or change colors (i.e., as desired by a user). A Data import/export 132 may be configured for importing and/or exporting data. Further, a camera icon 134 may exist and may be used to capture and store screenshots, which may be shared with another device (e.g., computer 110).

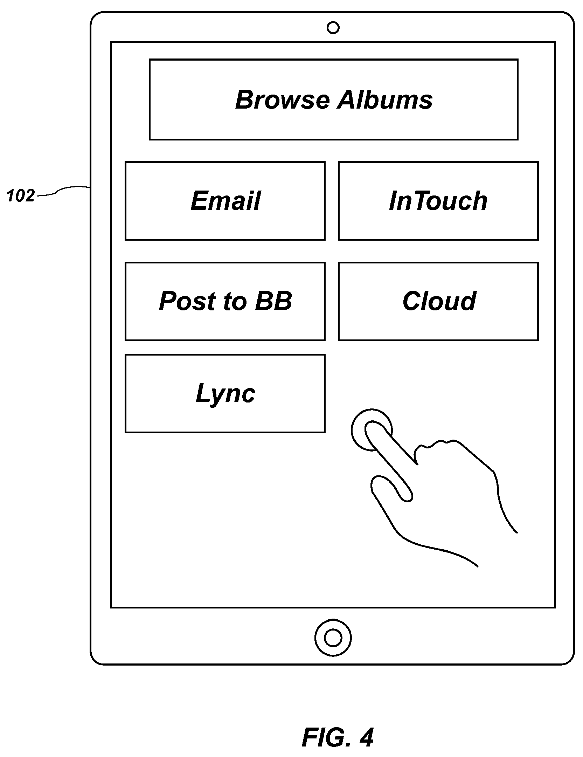

FIG. 4 depicts an example of message center 126 (see FIG. 2). Message center 126 may enable a user to browse albums and select results/screen captures, which may be conveyed to other computing devices (e.g., computer 110) through secure connections. For example, a user may convey results and/or screen captures to various project partners. Further, message center 126 may enable a user to live chat (e.g., through communication applications, such as "Lync", "BB," "InTouch"), store data in the Cloud, and/or send email.

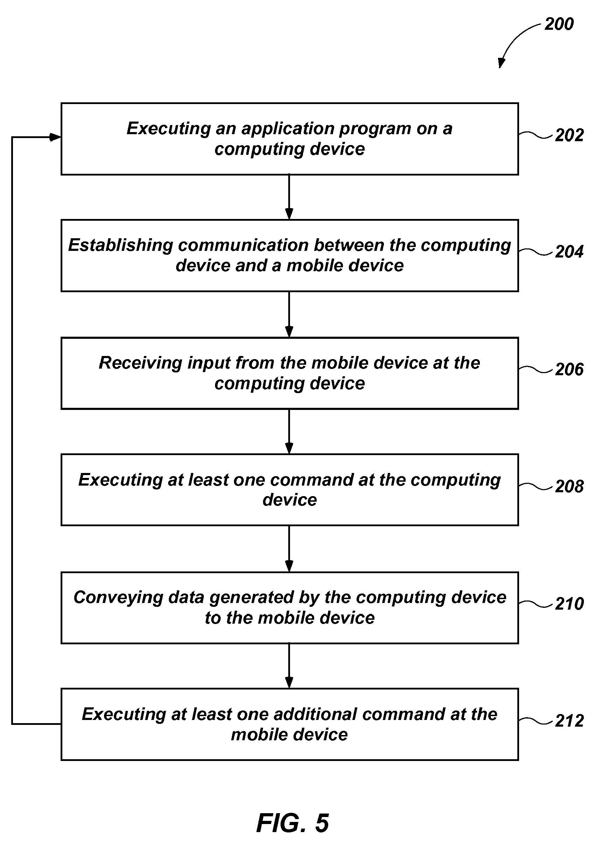

FIG. 5 is a flowchart of a method 200, according to an embodiment of the present disclosure. More specifically, method 200 may comprise a contemplated process of operating system 100 (see FIG. 1). Initially, an application program may be executed on computing device 104 (depicted by act 202). As an example, one or more simulation software programs (e.g., Petrel® Reservoir Engineering, Intersect® and Eclipse®) may be executed on computing device 104. Furthermore, method 200 may include establishing communication between mobile device 102 and computing device 104 (depicted by act 204). It is noted that communication may be established by computing device 104, mobile device 102, or a combination thereof. By way of example, a communication link comprising a wired link, a wireless link, or a combination thereof may be established between mobile device 102 and computing device 104. Method 200 may also include receiving input from mobile device 102 at computing device 104 (depicted by act 206). As an example, mobile device 102 may receive input from a user (e.g., via GUI 111).

Continuing with reference to FIG. 5, method 200 may include executing at least one command at computing device 104 (depicted by act 208). In addition, method 200 may include conveying data generated via computing device 104 to mobile device 102 (depicted by act 210). Method may further include executing at least one additional command at mobile device 102 (depicted by act 212). For example, the at least one additional command executed at mobile device 102 may be based on the data received from computing device 102 at mobile device 104. Further, it is noted that at any point of method 200, method 200 may return to act 202. For example, if, during a simulation, a user in unhappy with the simulation results, the user may iteratively change one or more settings of the settings (i.e., during or upon completion of the simulation).

As one example, simulation set-up menus in Petrel® Reservoir Engineering, Intersect® and/or Eclipse® may include setting an alarm if certain parameters exceed prespecified threshold during simulations. It is noted that the alarm may be conveyed via mobile device 102 and/or through sending a message (e.g., a text message) to a user. Mobile device 102 may further include a set-up menu may further include a live stream of data from intelligent fields for simulations to be used in a simulation data deck and/or for history matching.

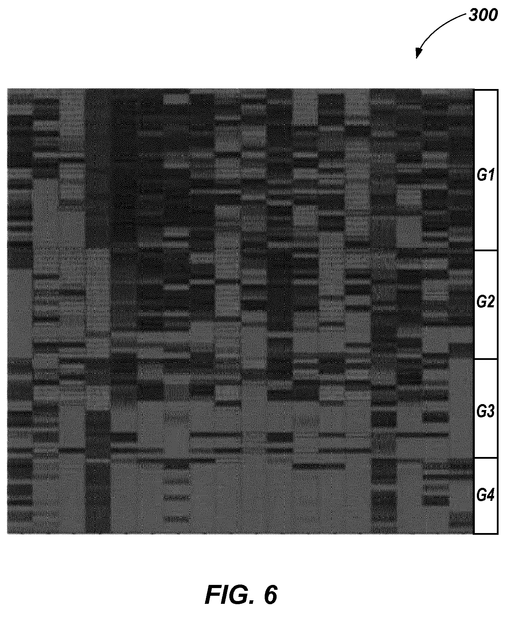

As noted above, screen display 120 (see FIG. 2) may include Results Management 124 (see FIG. 2). Results Management 124 may be configured for conveying simulation results in various formats. With reference to FIG. 6, a graph 300 of simulation results is depicted. As will be understood by a person having ordinary skill in the art, graph 600 includes several layers of information represented through size and color. More specifically, as an example, graph 600 may include a heatmap. Further, a classification/data mining component can be added to enhance details of visualization.

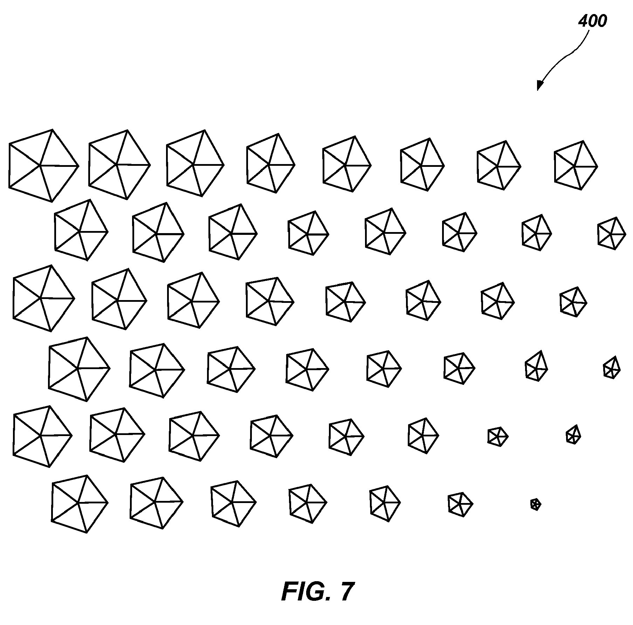

With reference to FIG. 7, a plot 400 of simulation results is depicted. As an example, plot 400 may include a star graph. As will be appreciated by a person having ordinary skill in the art, each star of plot 400 includes several parameters and may be used to convey high dimensional data (e.g. in history matching to compare multiple runs).

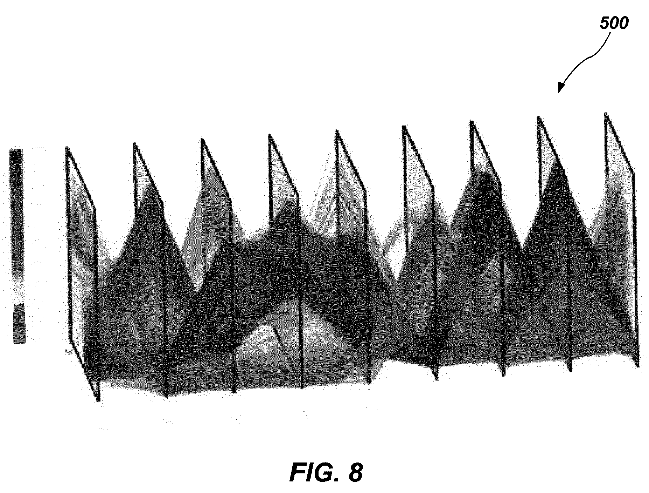

With reference to FIG. 8, a graph 500 of simulation results is depicted. As an example, graph 500 may include a parallel coordinates graph. As will be understood, vertical lines in graph 500 may represent a parameter (e.g. in history matching, unknown parameters). For each model in a history-matched ensemble (e.g., reservoir simulation), a horizontal line may intersect one or more vertical lines, wherein an intersection may comprise a parameter value.

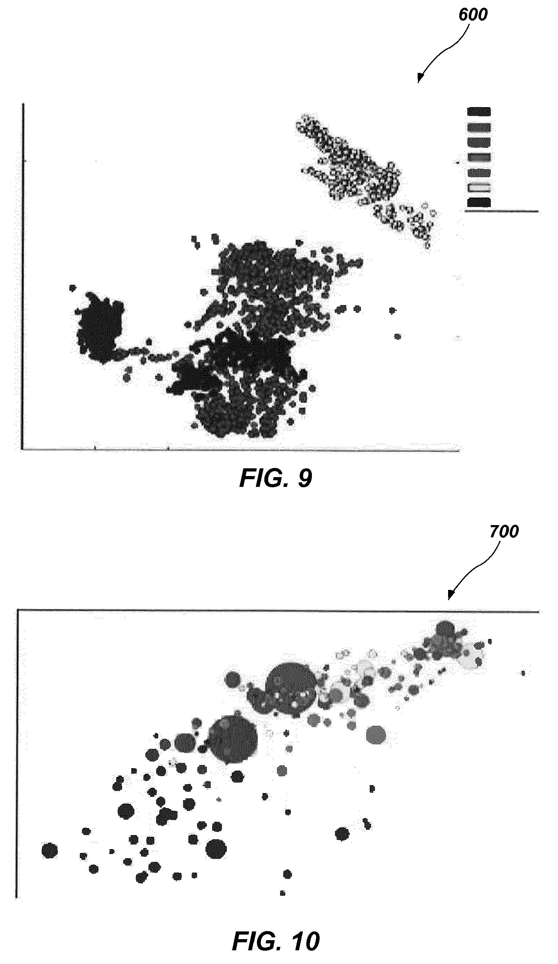

With reference to FIG. 9, a plot 600 of simulation results is shown. As an example, plot 600 may include a multidimensional projection graph. As will be appreciated by a person having ordinary skill in the art, a multidimensional projection graph may project high dimensional data (e.g. 50 unknowns or dimensions) to a 2D or 3D surface/space. For example, plot 600 may be based on a measurement algorithm, which attempts to maintain a distance in the lower dimensions as close as possible to the original dimensions. Plot 600 may be useful in discovering patterns/relationships between parameters.

As will be understood by a person having ordinary skill in the art, a Hans Rosling Gapminder tool, developed by Hans Rosling, may be used to visualize multiple dynamic behaviors of a reservoir over time (e.g. production rates, etc.). FIG. 10 depicts a plot 700 generated by a Hans Rosling's Gapminder tool. Size and color of the bubbles depicted in plot 700 may represent various attributes of data. Plot 700 may help to visualize changes during a specific period of time.

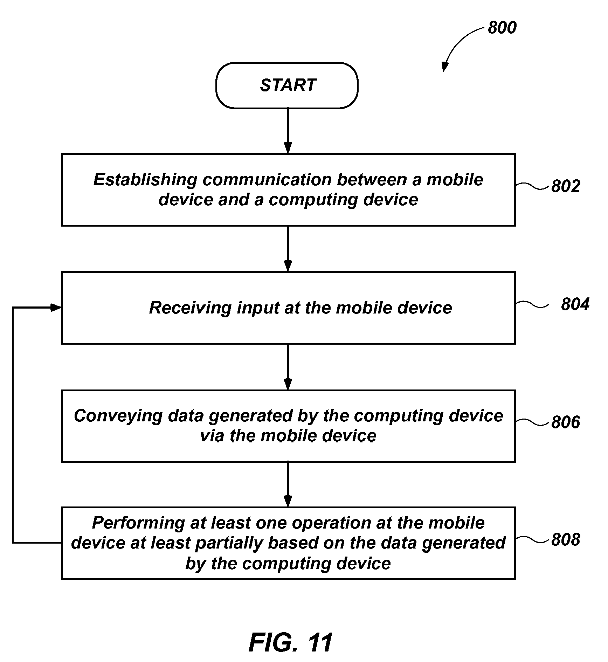

FIG. 11 is a flowchart of a method 800, according to an embodiment of the present disclosure. Method 800 may include establishing communication between a mobile device and a computing device (depicted by act 802). Method 800 may further include receiving input at the mobile device (depicted by act 804). In addition, method 800 may include conveying data generated by the computing device via the mobile device (depicted by act 806). Moreover, method 800 may include performing at least one operation at the mobile device at least partially based on the data generated by the computing device (depicted by act 808). Further, it is noted that at any point during method 800, method 800 may return to another act. Stated another way, in one example, after or during act 808, method 800 may return to act 804.

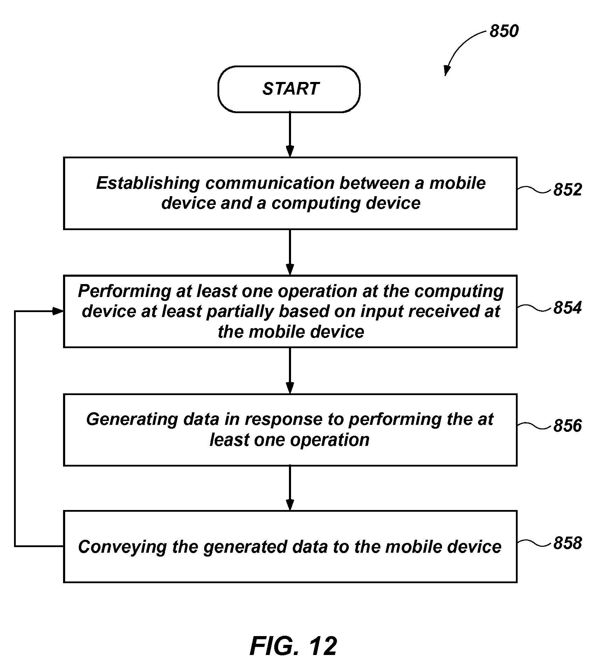

FIG. 12 is a flowchart of a method 850, according to another embodiment of the present invention. Method 850 includes establishing communication between a mobile device and a computing device (depicted by act 852). Method 850 further includes performing at least one operation at the computing device at least partially based on input received at the mobile device (depicted by act 854). In addition, method 850 may include generating data in response to performing the at least one operation (depicted by act 856). Further, method 850 may include conveying the generated data to the mobile device (depicted by act 858). It is noted that at any point during method 850, method 850 may return to another act. Stated another way, in one example, after or during act 858, method 850 may return to act 854.

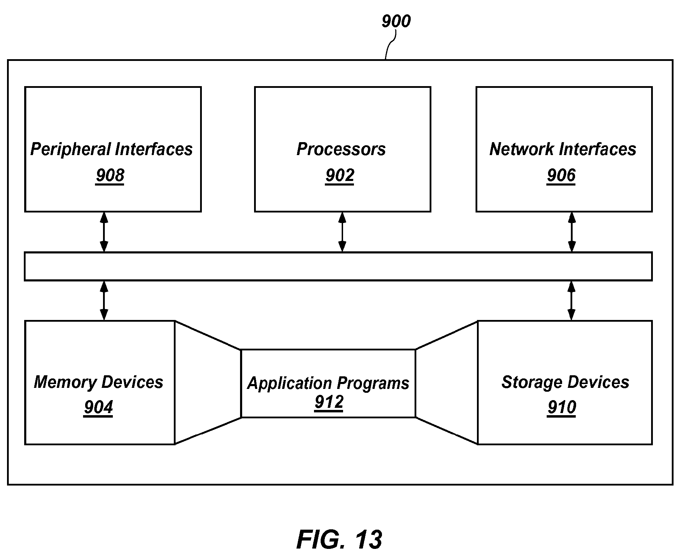

Embodiments of the disclosure may also include one or more systems for implementing one or more embodiments disclosed herein. FIG. 13 illustrates a schematic view of a processing system 900, according to an embodiment of the present disclosure. In an example, processing system 900 may be integrated within mobile device 102 (see FIGS. 1A and/or 1B), computing device 104 (see FIGS. 1A and/or 1B), another device, or any combination thereof. Processing system 900 may include one or more processors 902 of varying core configurations (including multiple cores) and clock frequencies. Processors 902 may be operable to execute instructions, apply logic, etc. It will be appreciated that these functions may be provided by multiple processors or multiple cores on a single chip operating in parallel and/or communicably linked together. In at least one embodiment, processors 902 may comprise and/or include one or more GPUs.

Processing system 900 may also include a memory system, which may be or include one or more memory devices and/or computer-readable media 904 of varying physical dimensions, accessibility, storage capacities, etc. such as flash drives, hard drives, disks, random access memory, etc., for storing data, such as images, files, and program instructions for execution by processors 902. In an embodiment, computer-readable media 904 may store instructions that, when executed by processors 902, are configured to cause processing system 900 to perform operations. For example, execution of such instructions may cause processing system 900 to implement one or more embodiments described herein.

Processing system 900 may also include one or more network interfaces 906, which may include any hardware, applications, and/or other software. Accordingly, network interfaces 906 may include Ethernet adapters, wireless transceivers, PCI interfaces, and/or serial network components, for communicating over wired or wireless media using protocols, such as Ethernet, wireless Ethernet, etc.

Processing system 900 may further include one or more peripheral interfaces 908, for communication with a display screen, projector, keyboards, mice, touchpads, sensors, other types of input and/or output peripherals, and/or the like. In some implementations, the components of processing system 900 need not be enclosed within a single enclosure or even located in close proximity to one another, but in other implementations, the components and/or others may be provided in a single enclosure.

Memory device 904 may be physically or logically arranged or configured to store data on one or more storage devices 910. Storage device 910 may include one or more file systems or databases in any suitable format. Storage device 910 may also include one or more application programs 912, which may contain interpretable or executable instructions for performing one or more of the disclosed processes. It is noted that application programs 912 may comprise application program 109, application program 117 (see FIG. 1B), or a combination thereof. When requested by processors 902, one or more of the application programs 912, or a portion thereof, may be loaded from storage devices 910 to memory devices 904 for execution by processors 902.

Those skilled in the art will appreciate that the above-described componentry is merely one example of a hardware configuration, as the processing system 900 may include any type of hardware components, including any necessary accompanying firmware or software, for performing the disclosed implementations. Processing system 900 may also be implemented in part or in whole by electronic circuit components or processors, such as application-specific integrated circuits (ASICs) or field-programmable gate arrays (FPGAs).

Although the foregoing description contains many specifics, these should not be construed as limiting the scope of the invention or of any of the appended claims, but merely as providing information pertinent to some specific embodiments that may fall within the scopes of the invention and the appended claims. Features from different embodiments may be employed in combination. In addition, other embodiments of the invention may also be devised which lie within the scopes of the invention and the appended claims. The scope of the invention is, therefore, indicated and limited only by the appended claims and their legal equivalents. All additions, deletions and modifications to the invention, as disclosed herein, that fall within the meaning and scopes of the claims are to be embraced by the claims.

## Claims

1. A method, comprising:
establishing communication between a mobile device and a computing device;
receiving input at the mobile device;
conveying data generated in response to at least one simulation performed at the computing device via the mobile device; and
performing at least one operation at the mobile device at least partially based on the data generated by the computing device.

2. The method of claim 1, further comprising receiving the data generated by the computing device at the mobile device.

3. The method of claim 1 or claim 2, wherein conveying data comprises conveying an oil production versus time plot.

4. The method of any one of the preceding claims, further comprising at least one of saving the generated data at the mobile device and transmitting the generated data to another device.

5. The method of any one of the preceding claims, further comprising performing the at least one simulation operation at the computing device at least partially based on the input received at the mobile device.

6. The method of any one of the preceding claims, wherein performing the at least one simulation operation at the computing device comprises performing at least one oil/gas reservoir simulation at the computing device.

7. A system, comprising:
a mobile device including an application program; and
a computing device communicatively coupled to the mobile device and including another application program configured to perform at least one simulation and convey data based on the at least one simulation to the application program of the mobile device.

8. The system of claim 7, wherein the application program of the mobile device is configured to:
receive input via a graphical user interface (GUI);
receive data from the computing device;
convey the data generated via the GUI; and
perform at least one operation based on the received data.

9. The system of claim 7 or claim 8, wherein the application program of the mobile device is further configured to convey at least one instruction to the computing device in response to input received via the GUI.

10. The system of any one of claims 7 to 9, the at least one instruction comprising at least one of build, launch, and control the at least one simulation.

11. A non-transitory computer-readable storage medium storing instructions that when executed by a processor cause the processor to perform instructions, the instructions comprising:
receiving input at the mobile device;
conveying data based on at least one simulation performed via the computing device via the mobile device; and
performing at least one operation at the mobile device at least partially based on the conveyed data.

12. The non-transitory computer-readable storage medium of claim 11, wherein conveying data comprises conveying at least one of a heatmap graph, a star graph, a parallel coordinate graph, a multidimensional projection plot, and a Hans Rosling gapminder plot.

13. The non-transitory computer-readable storage medium of claim 11 or claim 12, wherein conveying data comprises conveying an oil/gas production versus time plot.

14. The non-transitory computer-readable storage medium of any one of claims 11 to 13, the instructions further comprising transmitting the data to another computing device.

15. The non-transitory computer-readable storage medium of any one of claims 11 to 14, the instructions further comprising conveying at least one instruction to the computing device based at least partially on the receiving input, the conveying at least instruction comprising conveying at least instruction to build or launch the at least one simulation on the computing device.
